# EUROPEAN PATENT APPLICATION

(11) **EP 4 632 567 A1**
(43) Date of publication of application: **15.10.2025**
(21) Application number: 23917056.6
(22) Date of filing: 15.09.2023
(51) Int. Cl.: G06F 9/455

(54) **METHOD AND APPARATUS FOR PROCESSING PAGE FAULT OF MEMORY ACCESS**

(30) Priority: 20.01.2023 CN 202310104641
(71) Applicant: Huawei Technologies Co., Ltd., Shenzhen, Guangdong 518129 (CN)
(72) Inventor: YE, Feng, Shenzhen, Guangdong 518129 (CN); CHENG, Chuanning, Shenzhen, Guangdong 518129 (CN)
(74) Representative: Huawei European IPR
(86) International application number: PCT/CN2023/119165
(87) International publication number: WO 2024/152588

(57) **Abstract**

Embodiments of this application relate to the field of communication technologies, and provide a method and an apparatus for processing a page fault in memory access, to reduce network congestion caused by the page fault. The method for processing the page fault in memory access includes: sending a first access request, where the first access request is used to access memory, and the first access request includes a first virtual address; receiving the first access request, and sending a first response, where the first response carries page fault information, and the page fault information indicates a fault type of a page fault corresponding to the first virtual address; and receiving the first response, to process a related access request based on the fault type indicated by the page fault information carried in the first response. This reduces waiting time for completing page missing processing, and reduces network congestion caused by the page fault.

## Description

This application claims priority to Chinese Patent Application No. 202310104641.0, filed with the China National Intellectual Property Administration on January 20, 2023 and entitled "METHOD AND APPARATUS FOR PROCESSING PAGE FAULT IN MEMORY ACCESS", which is incorporated herein by reference in its entirety.

### TECHNICAL FIELD

This application relates to the field of communication technologies, and in particular, to a method and an apparatus for processing a page fault in memory access.

### BACKGROUND

In a distributed computing scenario, a large amount of data usually needs to be shared between different nodes. Currently, when data needs to be shared between different nodes, memory reservation (pinned memory) is used to ensure performance, and memory spaces are pre-allocated to different nodes to avoid a page fault (page fault). However, a large quantity of reserved memory spaces means that a large quantity of memory spaces is consumed. As a system grows larger, the memory may be exhausted. Therefore, how to handle a page fault in memory access is a technical problem to be urgently resolved.

### SUMMARY

This application provides a method and an apparatus for processing a page fault in memory access, to reduce network congestion caused by the page fault.

To achieve the foregoing objective, this application uses the following technical solutions.

According to a first aspect, a method for processing a page fault in memory access is provided. The method includes: A first node receives a first access request from a second node. The first access request is used to access memory, and the first access request includes a first virtual address. The first node sends a first response to the second node. The first response carries page fault information, and the page fault information indicates a fault type of a page fault corresponding to the first virtual address.

In the foregoing technical solution, the first node may receive the first access request from the second node, and send the first response to the second node when the first virtual address included in the first access request is subjected to a page fault. The first response carries the page fault information, and the page fault information indicates the fault type of the page fault corresponding to the first virtual address. Therefore, the second node may process the first access request in time based on the fault type of the page fault, or process a plurality of access requests related to the fault type, to reduce time for the second node to wait for completion of page missing processing, and reduce network congestion caused by the page fault.

In a possible implementation of the first aspect, the fault type is at least one of the following types: retry, abort, stream accessed by the first access request disabled, and system memory management unit SMMU disabled. In the foregoing possible implementation, several fault types are provided, so that when receiving the first response carrying the page fault information, the second node can effectively process, based on the fault type of the page fault, an access request related to the fault type in time. This reduces a page fault processing delay, and reduces congestion caused by the delay.

In a possible implementation of the first aspect, the page fault information indicates that the fault type is the retry, and the method further includes: The first node sends a retry prompt to the second node. The retry prompt indicates at least one of the following information: a first page table corresponding to the first virtual address has been created, the first page table corresponding to the first virtual address fails to be created, and write behavior of a page request interface PRI triggered by the page fault is abnormal. In the foregoing possible implementation, several types of information indicated by the retry prompt are provided, so that when receiving the retry prompt, the second node can effectively process, based on the retry prompt, an access request related to the information indicated by the retry prompt in time. This further reduces the page fault processing delay, and improves processing efficiency.

In a possible implementation of the first aspect, the retry prompt indicates that the first page table corresponding to the first virtual address has been created, and the method further includes: The first node receives the first access request sent by the second node based on the retry prompt; and determines, based on the first page table, a first physical address corresponding to the first virtual address, and accesses the memory based on the first physical address. In the foregoing possible implementation, the first node receives the first access request sent by the second node based on the retry prompt; determines, based on the first page table, the first physical address corresponding to the first virtual address, and accesses the memory based on the first physical address. This reduces a waiting delay of the second node, and improves processing efficiency.

In a possible implementation of the first aspect, if a result of a page table walk performed based on the first virtual address is a fault, the page fault information indicates that the fault type of the page fault is the abort. In the foregoing possible implementation, the page fault processing delay can be reduced, and congestion caused by the delay can be reduced.

In a possible implementation of the first aspect, the page fault information further indicates a page table granularity corresponding to the page fault. In the foregoing possible implementation, the second node can abort, based on the page table granularity, another access request that corresponds to a same page table as the first access request, to avoid congestion of the first node.

In a possible implementation of the first aspect, the first response further indicates required waiting time for resending the first access request, and the required waiting time may be time taken for completing previous page fault processing. In the foregoing possible implementation, accuracy of the time may be improved, to reduce the page fault processing delay to some extent, and reduce congestion caused by the delay.

In a possible implementation of the first aspect, before the first node sends the first response to the second node, the method further includes: The first node determines, based on the first virtual address, that a page fault occurs.

According to a second aspect, a method for processing a page fault in memory access is provided. The method includes: A second node sends a first access request to a first node. The first access request is used to access memory, and the first access request includes a first virtual address. The second node receives a first response from the first node. The first response carries page fault information, and the page fault information indicates a fault type of a page fault corresponding to the first virtual address.

In the foregoing technical solution, the second node may send the first access request to the first node, where the first access request includes the first virtual address; and receives the first response from the first node. The first response carries the page fault information, and the page fault information indicates the fault type of the page fault corresponding to the first virtual address. Therefore, the second node may process the first access request in time based on the fault type of the page fault, or process a plurality of access requests related to the fault type, to reduce a page fault processing delay, and reduce congestion caused by the delay.

In a possible implementation of the second aspect, the method further includes: The second node processes, based on the fault type that is of the page fault and that is indicated by the page fault information, one or more access requests corresponding to the fault type. The one or more access requests include the first access request. In the foregoing possible implementation, the second node may process the first access request in time based on the fault type of the page fault, or process the plurality of access requests related to the fault type, to reduce the page fault processing delay, and reduce congestion caused by the delay.

In a possible implementation of the second aspect, the fault type is at least one of the following types: retry, abort, stream accessed by the first access request disabled, and system memory management unit SMMU disabled. In the foregoing possible implementation, several fault types are provided, so that when receiving the first response carrying the page fault information, the second node can effectively process, based on the fault type of the page fault, an access request related to the fault type in time. This reduces the page fault processing delay, and reduces congestion caused by the delay.

In a possible implementation of the second aspect, the page fault information indicates that the fault type is the retry, and the method further includes: The second node receives a retry prompt from the first node. The retry prompt indicates at least one of the following information: a first page table corresponding to the first virtual address has been created, the first page table corresponding to the first virtual address fails to be created, and write behavior of a page request interface PRI triggered by the page fault is abnormal.

In a possible implementation of the second aspect, the retry prompt indicates that the first page table corresponding to the first virtual address has been created, and the method further includes: The second node sends the first access request to the first node based on the retry prompt. The retry prompt indicates that the first page table corresponding to the first virtual address fails to be created, or indicates that the write behavior of the PRI triggered by the page fault is abnormal, and the method further includes: The second node aborts or skips sending of the first access request based on the retry prompt. In the foregoing possible implementation, several types of information indicated by the retry prompt are provided, so that when receiving the retry prompt, the second node can effectively process, based on the retry prompt, an access request related to the information indicated by the retry prompt in time. This further reduces the page fault processing delay, and improves processing efficiency.

In a possible implementation of the second aspect, the page fault information indicates that the fault type is the abort, and the method further includes: The second node aborts or skips sending of the first access request based on the page fault information. In the foregoing possible implementation, the page fault processing delay can be reduced, and congestion caused by the delay can be reduced.

In a possible implementation of the second aspect, the page fault information further indicates a page table granularity corresponding to the page fault, and the first access request and at least one second access request correspond to a same page table at the page table granularity. Optionally, the method further includes: When the page fault information indicates that the fault type is the retry, the second node suspends sending of the at least one second access request. When the page fault information indicates that the fault type is the abort, the second node aborts or skips sending of the at least one second access request. In the foregoing possible implementation, the second node can process, based on the page table granularity, another access request that corresponds to a same page table as the first access request, to avoid congestion of the first node.

In a possible implementation of the second aspect, the page fault information indicates that the fault type is the stream accessed by the first access request disabled, and the method further includes: The second node aborts or skips sending of a plurality of access requests corresponding to the stream, where the plurality of access requests include the first access request. In the foregoing possible implementation, the second node can abort, based on the page table granularity, another access request that corresponds to a same page table as the first access request, to avoid congestion of the first node.

In a possible implementation of the second aspect, the page fault information indicates that the fault type is the SMMU disabled, and the method further includes: The second node aborts or skips sending of a plurality of access requests corresponding to the SMMU, where the plurality of access requests include the first access request. In the foregoing possible implementation, the second node aborts the plurality of access requests corresponding to the SMMU, to avoid congestion of the first node.

In a possible implementation of the second aspect, the first response further indicates required waiting time for resending the first access request, and the required waiting time may be time taken for completing previous page fault processing. In the foregoing possible implementation, accuracy of the time may be improved, to reduce the page fault processing delay to some extent, and reduce congestion caused by the delay.

According to a third aspect, an apparatus for processing a page fault in memory access is provided. The apparatus includes: a receiving unit, configured to receive a first access request from a second node, where the first access request is used to access memory, and the first access request includes a first virtual address; and a sending unit, configured to send a first response to the second node, where the first response carries page fault information, and the page fault information indicates a fault type of a page fault corresponding to the first virtual address.

In a possible implementation of the third aspect, the fault type is at least one of the following types: retry, abort, stream accessed by the first access request disabled, and system memory management unit SMMU disabled.

In a possible implementation of the third aspect, the page fault information indicates that the fault type is the retry. The sending unit is further configured to send a retry prompt to the second node. The retry prompt indicates at least one of the following information: a first page table corresponding to the first virtual address has been created, the first page table corresponding to the first virtual address fails to be created, and write behavior of a page request interface PRI triggered by the page fault is abnormal.

In a possible implementation of the third aspect, the retry prompt indicates that the first page table corresponding to the first virtual address has been created, and the apparatus further includes a processing unit. The receiving unit is further configured to receive the first access request sent by the second node based on the retry prompt. The processing unit is further configured to determine, based on the first page table, a first physical address corresponding to the first virtual address, and access the memory based on the first physical address.

In a possible implementation of the third aspect, if a result of a page table walk performed based on the first virtual address is a fault, the page fault information indicates that the fault type of the page fault is the abort.

In a possible implementation of the third aspect, the page fault information further indicates a page table granularity corresponding to the page fault.

In a possible implementation of the third aspect, the first response further indicates required waiting time for resending the first access request, and the required waiting time may be time taken for completing previous page fault processing.

In a possible implementation of the third aspect, the apparatus further includes the processing unit, configured to determine, based on the first virtual address, that a page fault occurs.

According to a fourth aspect, an apparatus for processing a page fault in memory access is provided. The apparatus includes: a sending unit, configured to send a first access request to a first node, where the first access request is used to access memory, and the first access request includes a first virtual address; and a receiving unit, configured to receive a first response from the first node, where the first response carries page fault information, and the page fault information indicates a fault type of a page fault corresponding to the first virtual address.

In a possible implementation of the fourth aspect, the apparatus further includes a processing unit, configured to process, based on the fault type that is of the page fault and that is indicated by the page fault information, one or more access requests corresponding to the fault type, where the one or more access requests include the first access request.

In a possible implementation of the fourth aspect, the fault type is at least one of the following types: retry, abort, stream accessed by the first access request disabled, and system memory management unit SMMU disabled.

In a possible implementation of the fourth aspect, the page fault information indicates that the fault type is the retry. The receiving unit is further configured to receive a retry prompt from the first node. The retry prompt indicates at least one of the following information: a first page table corresponding to the first virtual address has been created, the first page table corresponding to the first virtual address fails to be created, and write behavior of a page request interface PRI triggered by the page fault is abnormal.

In a possible implementation of the fourth aspect, if the retry prompt indicates that the first page table corresponding to the first virtual address has been created, the sending unit is further configured to send the first access request to the first node based on the retry prompt. If the retry prompt indicates that the first page table corresponding to the first virtual address fails to be created, or indicates that the write behavior of the PRI triggered by the page fault is abnormal, and the apparatus further includes the processing unit, configured to abort or skip sending of the first access request based on the retry prompt.

In a possible implementation of the fourth aspect, the page fault information indicates that the fault type is the abort, and the apparatus further includes the processing unit, configured to abort or skip sending of the first access request based on the page fault information.

In a possible implementation of the fourth aspect, the page fault information further indicates a page table granularity corresponding to the page fault, and the first access request and at least one second access request correspond to a same page table at the page table granularity. Optionally, the apparatus further includes the processing unit, configured to: when the page fault information indicates that the fault type is the retry, suspend sending of the at least one second access request. The processing unit is further configured to: when the page fault information indicates that the fault type is the abort, abort or skip sending of the at least one second access request.

In a possible implementation of the fourth aspect, the page fault information indicates that the fault type is the stream accessed by the first access request disabled, and the apparatus further includes the processing unit, configured to abort or skip sending of a plurality of access requests corresponding to the stream, where the plurality of access requests include the first access request.

In a possible implementation of the fourth aspect, the page fault information indicates that the fault type is the SMMU disabled, and the apparatus further includes the processing unit, configured to abort or skip sending of a plurality of access requests corresponding to the SMMU, where the plurality of access requests include the first access request.

In a possible implementation of the fourth aspect, the first response further indicates required waiting time for resending the first access request, and the required waiting time may be time taken for completing previous page fault processing.

According to a fifth aspect, an apparatus for processing a page fault in memory access is provided. The apparatus includes a processor and a memory, the memory stores instructions, and when the processor runs the instructions, the apparatus is enabled to perform the method in the first aspect or any one of the possible implementations of the first aspect.

According to a sixth aspect, an apparatus for processing a page fault in memory access is provided. The apparatus includes a processor and a memory, the memory stores instructions, and when the processor runs the instructions, the apparatus is enabled to perform the method in the second aspect or any one of the possible implementations of the second aspect.

According to a seventh aspect, a server is provided. The server includes a processor, a memory, and a communication interface that are coupled to each other. The memory stores instructions, and the processor is configured to execute the instructions in the memory, and perform communication through the communication interface, so that the server performs the method in the first aspect or any one of the possible implementations of the first aspect.

According to an eighth aspect, a server is provided. The server includes a processor, a memory, and a communication interface that are coupled to each other. The memory stores instructions, and the processor is configured to execute the instructions in the memory, and perform communication through the communication interface, so that the server performs the method in the second aspect or any one of the possible implementations of the second aspect.

According to another aspect, this application provides a communication network. The communication network includes a first node and a second node. The first node includes the apparatus in the third aspect or any one of the possible implementations of the third aspect, the fifth aspect, or the seventh aspect. The second node includes the apparatus provided in the fourth aspect or any one of the possible implementations of the fourth aspect, the sixth aspect, or the eighth aspect.

According to another aspect, this application provides a chip. The chip includes a processor and an interface circuit. The interface circuit is configured to support the processor in communicating with an off-chip memory, and the processor is configured to perform the method in the first aspect or any one of the possible implementations of the first aspect, or the method in the second aspect or any one of the possible implementations of the second aspect.

According to another aspect, this application provides a chip system. The chip system is configured to perform the method in the first aspect or any one of the possible implementations of the first aspect, or the method in the second aspect or any one of the possible implementations of the second aspect.

According to another aspect, this application provides a vehicle. The vehicle is configured to perform the method in the first aspect or any one of the possible implementations of the first aspect, or the method in the second aspect or any one of the possible implementations of the second aspect.

According to another aspect, this application provides a computer-readable storage medium. The computer-readable storage medium stores a computer program or instructions, and when the computer program or the instructions is/are run, the method in the first aspect or any one of the possible implementations of the first aspect is implemented.

According to another aspect, this application provides a computer-readable storage medium. The computer-readable storage medium stores a computer program or instructions, and when the computer program or the instructions is/are run, the method in the second aspect or any one of the possible implementations of the second aspect is implemented.

According to another aspect, this application provides a computer program product. The computer program product includes a computer program (which may also be referred to as code or instructions), and when the computer program is run, a computer is enabled to perform the method in the first aspect or any one of the possible implementations of the first aspect.

According to another aspect, this application provides a computer program product. The computer program product includes a computer program (which may also be referred to as code or instructions), and when the computer program is run, a computer is enabled to perform the method in the second aspect or any one of the possible implementations of the second aspect.

It may be understood that, for beneficial effect that can be achieved by any one of the apparatus for processing the page fault in memory access, the server, the communication network, the chip, the chip system, the computer-readable storage medium, and the computer program product that are provided above, refer to beneficial effect in the corresponding method for processing the page fault in memory access provided above.

### BRIEF DESCRIPTION OF DRAWINGS

FIG. 1 is a diagram of a structure of a communication network according to an embodiment of this application;
FIG. 2 is a diagram of structures of a requester and a responder according to an embodiment of this application;
FIG. 3 is a schematic flowchart of a method for processing a page fault in memory access according to an embodiment of this application;
FIG. 4 is a diagram of page fault processing according to an embodiment of this application;
FIG. 5 is a schematic flowchart of another method for processing a page fault in memory access according to an embodiment of this application;
FIG. 6 is a diagram of a structure of a first node according to an embodiment of this application;
FIG. 7 is a diagram of a structure of another first node according to an embodiment of this application;
FIG. 8 is a diagram of a structure of a second node according to an embodiment of this application; and
FIG. 9 is a diagram of a structure of another second node according to an embodiment of this application.

### DESCRIPTION OF EMBODIMENTS

The following describes technical solutions in embodiments of this application with reference to accompanying drawings in embodiments of this application. In this application, "at least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" usually indicates an "or" relationship between the associated objects. At least one of the following items (pieces) or a similar expression thereof refers to any combination of these items, including any combination of singular items (pieces) or plural items (pieces). For example, at least one item (piece) of a, b, or c may represent: a, b, c, a and b, a and c, b and c, or a, b, and c, where a, b, and c may be singular or plural. In addition, in embodiments of this application, terms such as "first" and "second" do not limit a quantity or an execution sequence.

It should be noted that, in this application, the word such as "example" or "for example" represents giving an example, an illustration, or a description. Any embodiment or design scheme described as an "example" or "for example" in this application should not be explained as being more preferred or having more advantages than another embodiment or design scheme. To be precise, use of the word such as "example" or "for example" is intended to present a relative concept in a specific manner.

In a distributed computing scenario, a large amount of data usually needs to be shared between different nodes. Currently, when data needs to be shared between different nodes, memory reservation (pinned memory) is used to ensure performance, and memory spaces are pre-allocated to different nodes to avoid a page fault (page fault). However, a large quantity of pinned memory spaces means that a large quantity of memory spaces is consumed. As a system grows larger, the memory may be exhausted. On-demand (on-demand) memory allocation can avoid such a problem. However, due to a microsecond-level page missing processing delay and congestion caused by the delay, the manner cannot be applied to a plurality of scenarios.

The technical solutions provided in this application may be applied to a communication network. The communication network may include a plurality of network nodes. The plurality of network nodes may communicate with each other over a network (network). The communication may be implemented according to network transmission protocols such as remote direct memory access (remote direct memory access, RDMA) and unified bus (unified bus, UB), for example, to implement high-speed serial transmission. For example, the communication network may include a data center network (data center network, DCN), a high performance computing (high performance computing, HPC) network, or a cloud network. The network node in the communication network may also be referred to as a node for short, and the node may be a computer, a server, or the like.

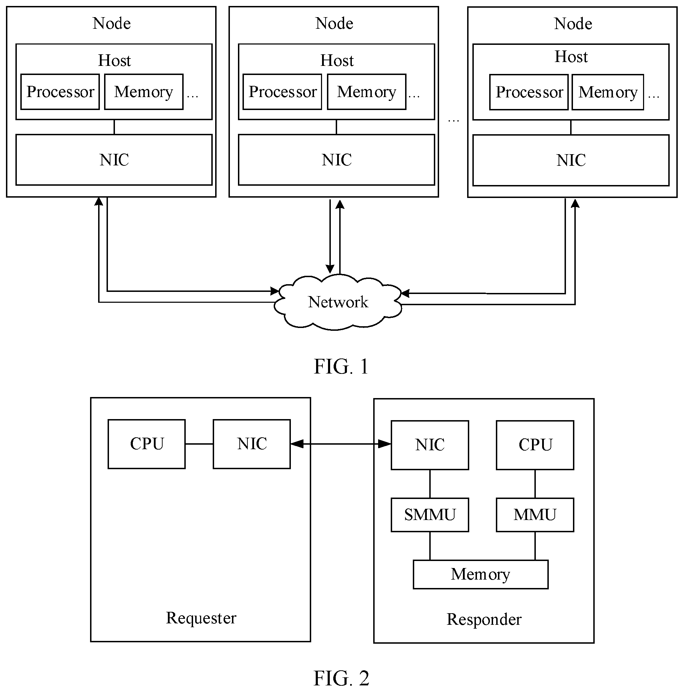

For example, as shown in FIG. 1, the communication network includes a plurality of nodes, and the plurality of nodes are connected over the network. Data may be shared between different nodes in the plurality of nodes. For example, data may be transmitted between any two nodes in the plurality of nodes, for example, data is transmitted through high-speed serial transmission. Each of the plurality of network nodes may include a host (host) and a network interface card (network interface card, NIC), and the network interface card may also be referred to as a network interface controller. The host may include a processor, a memory (memory), a memory management unit (memory management unit, MMU), and the like. For example, the processor may be a central processing unit (central processing unit, CPU), and the memory may be a memory (which may be referred to as a memory). Optionally, the memory may be a dynamic random access memory (dynamic random access memory, DRAM) or a double data rate (double data rate, DDR) memory.

In embodiments of this application, when data is shared between the plurality of nodes included in the communication network, each of the plurality of nodes may perform on-demand memory allocation. In a possible embodiment, when a node needs to share data with another node, the node may apply, in the on-demand manner, to the another node for a memory that can be used to store the data. After obtaining the memory through application, the node may send a memory access request used to access the memory. In another possible embodiment, when data sharing between a node and another node is completed, the another node may release a memory that is applied for by the node and that is used to store data. On-demand memory allocation is performed, so that a large quantity of memory spaces is not reserved in the node, and the memory is not exhausted as a system grows larger.

As shown in FIG. 2, when data is shared between two nodes in the communication network, a memory user (namely, a node that initiates a memory access request) may be referred to as a requester (requester), and a memory provider (namely, a node that receives the memory access request) may be referred to as a responder (responder). For example, the requester may include a CPU and a NIC, and the responder may include a CPU, an MMU, a memory, a system memory management unit (system memory management unit, SMMU), and a NIC. The NIC may include a protocol agent (agent). For example, the protocol agent may be an RDMA agent or a UB agent (which may be referred to as an UBA for short). In FIG. 2, the protocol agent is represented as an RDMA/UB agent. In addition, when the protocol agent in the NIC is a UBA, the SMMU may also be replaced with a UBMMU.

It may be understood that structures of the requester and the responder shown in FIG. 2 are merely examples. During actual application, the requester and the responder may further include more or fewer components than those shown in the figure, or a combination of some components, or components disposed differently. FIG. 2 does not constitute a limitation on embodiments of this application.

Before the technical solutions of this application are described, the following first describes related technical terms in embodiments of this application.

A virtual address (virtual address, VA) may be an address that can be identified or generated by a processor in a virtual address space. A physical address (physical address, PA) may be an address, in a physical address space, of a hardware storage device like a memory. When the processor needs to access the memory, the processor may provide a virtual address, and the MMU may map the virtual address to a physical address, that is, translate access to the virtual address into access to a physical memory, so that the processor can write data into or read data from the memory based on the physical address.

A page table (page table) may be a special data structure stored in the memory, and may specifically indicate a mapping relationship between a virtual address in a specific virtual address space and a physical address. The page table may have a plurality of different page table granularities, that is, the page table may indicate mapping relationships between virtual addresses and physical addresses at different granularities.

A page fault (page fault) may also be referred to as page missing, and is a fault that occurs in a memory access process. Specifically, when the memory is accessed based on a virtual address, the virtual address cannot be mapped to a physical address based on a page table. For example, there is no page table corresponding to the virtual address, or the physical address corresponding to the virtual address cannot be found based on an existing page table.

The following describes specific content of a method for processing a page fault in memory access provided in embodiments of this application.

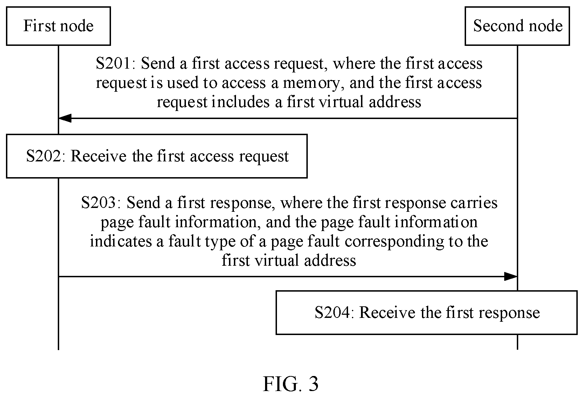

FIG. 3 is a schematic flowchart of a method for processing a page fault in memory access according to an embodiment of this application. The method may be applied to a communication network including a first node and a second node. The first node and the second node may be respectively the responder and the requester shown in FIG. 2. The method includes the following steps.

S201: The second node sends a first access request to the first node, where the first access request is used to access memory, and the first access request includes a first virtual address.

The memory that is accessed using the first access request may be located in the first node. In other words, the first node is configured to provide the memory, so that the first node may be the foregoing responder. The second node is configured to use the memory, so that the second node may be the foregoing requester. Optionally, the first access request may be a write request or a read request. In other words, the second node may write data into the memory, or may read data from the memory.

In addition, the first virtual address may include a virtual address at a specific granularity. For example, the granularity of the first virtual address may be 4 KB, 16 KB, 64 KB, or the like. This is not specifically limited in embodiments of this application. Optionally, the first virtual address may be represented in a form of base address and length.

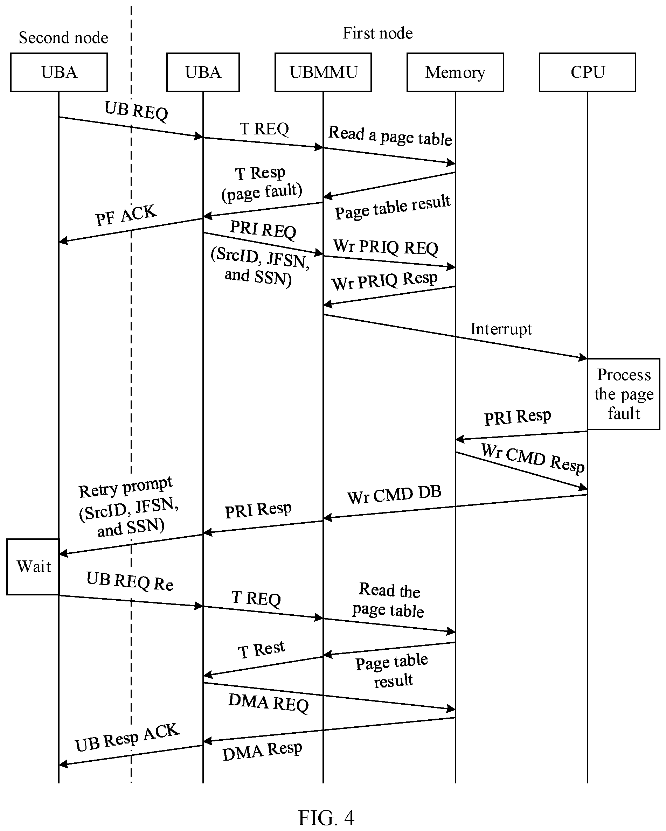

In a possible embodiment, when the second node needs to access the memory in the first node, the second node may send, to the first node, the first access request used to access the memory. The first access request may include the first virtual address. For example, FIG. 4 shows an example in which the method provided in FIG. 3 is applied to the architecture shown in FIG. 2. The second node includes a CPU and a NIC, and the NIC includes a UBA (the CPU and the NIC are not shown in FIG. 4). When a process that is run in the CPU of the second node needs to access the memory in the first node, the CPU may send the first access request to the NIC, and the UBA of the NIC sends, to the second node, the first access request UB REQ carrying the first virtual address. The first access request may further include an identifier SrcID of the second node, an identifier JFSN of the process, and a send sequence number SSN of the request. FIG. 4 shows only the UBA of the second node.

S202: The first node receives the first access request from the second node. Related descriptions of the first access request are consistent with those of the first access request in step S201. Details are not described herein again in this embodiment of this application.

In a possible embodiment, when the first node receives the first access request, the first node may walk a currently created page table based on the first virtual address carried in the first access request. If a first physical address corresponding to the first virtual address is found (that is, a hit) in the currently created page table, the first node may access the memory based on the first physical address. If the first physical address corresponding to the first virtual address is not found (that is, a miss) in the currently created page table, the first node may determine that a page fault occurs.

Optionally, when walking the currently created page table based on the first virtual address, the first node may first walk a page table cache in the NIC, where the page table cache may be used to cache the page table. If the first physical address corresponding to the first virtual address is not found (that is, a miss) in the page table cache, the first node looks up, by using an SMMU or a UBMMU, the first physical address corresponding to the first virtual address. If the lookup fails, the first node may determine that a page fault occurs.

For example, still refer to FIG. 4 in which the method provided in FIG. 3 is applied to the architecture shown in FIG. 2. The first node may include a CPU, an MMU, a memory, a UBMMU, and a NIC, and the NIC includes a UBA. A process in which the first node determines that a page fault occurs may include: When the UBA of the first node receives the first access request UB REQ, and a page table cache walk is a miss, the UBA may initiate an address translation (translation) request T REQ to the UBMMU. When receiving T REQ, the UBMMU may read a page table (namely, a page table walk) from the memory. The memory may return a page table result (namely, a page table result) to the UBMMU. When the page table result, of the page table walk, returned by the memory is a failure, the UBMMU may send an address translation response T Resp to the UBA, where T Resp indicates that a page fault occurs. When receiving T Resp, the UBA may determine that a page fault occurs.

S203: The first node sends a first response to the second node, where the first response carries page fault information, and the page fault information indicates a fault type of a page fault corresponding to the first virtual address.

Optionally, the fault type is at least one of the following types: retry (retry), abort (abort), stream accessed by the first access request disabled (stream disabled), and SMMU disabled. The stream accessed by the first access request disabled may be referred to as stream disabled for short, and the SMMU disabled may also be referred to as global disabled (global disabled).

The fault type being the retry may mean that the page fault is a page fault in a common sense, for example, the walked page table is not created. The fault type being the abort may mean that a fault occurs in the page table walk. For example, the CPU has created the page table but cannot find the page table, or a virtual address being looked up exceeds an address range available for lookup. The fault type being the stream disabled may mean that the stream that the first access request currently needs to access is disabled, that is, cannot be accessed. The fault type being the SMMU disabled may mean that the SMMU configured to manage the memory accessed by the first access request is disabled.

It may be understood that, when the NIC uses different communication protocols, the SMMU corresponds to different names during actual application. For example, when the communication protocol is a UB protocol, the SMMU may be specifically a UBMMU. In some examples below, the SMMU being a UBMMU is used for description.

For example, as shown in Table 1, the first response may include a fault code (fault code) field with 2 bits (2 bits), and the fault code field indicates the fault type. If a value of the 2 bits is 00, it may indicate that the fault type is the retry. If the value of the 2 bits is 01, it may indicate that the fault type is the abort. If the value of the 2 bits is 10, it may indicate that the fault type is stream disabled. If the value of the 2 bits is 11, it may indicate that the fault type is global disabled.

**Table 1**

| Fault code (2 bits) | Fault type |
|---|---|
| 00 | Retry |
| 01 | Abort |
| 10 | Stream disabled |
| 11 | Global disabled |

It may be understood that fault codes corresponding to different fault types and quantities of bits corresponding to the fault codes shown in Table 1 are merely examples. During actual application, there may alternatively be another correspondence between the fault type and the fault code. Table 1 does not constitute a limitation on embodiments of this application.

In a possible embodiment, when determining, based on the first virtual address, that a page fault occurs, the first node may send the first response to the second node. For example, as shown in FIG. 4, after receiving T Resp and determining that a page fault occurs, the UBA of the first node may send, to the UBA of the second node, the first response carrying the page fault information. In FIG. 4, the first response is represented as PF ACK. Optionally, the first response PF ACK may further include the identifier SrcID of the second node, the identifier JFSN of the process, and the send sequence number SSN of the request. If the fault type indicated by the page fault information is the retry, the second node may wait for a retry prompt in the following.

Optionally, when the fault type indicated by the page fault information is the retry or the abort, the page fault information may further indicate a page table granularity corresponding to the page fault. For example, the page table granularity may include but is not limited to 4 KB, 16 KB, 64 KB, 2 MB, 32 MB, 512 MB, 1 GB, and 16 GB. For example, as shown in Table 2, the first response may further include a page table granularity field with 3 bits (3 bits), and the page table granularity field indicates the page table granularity corresponding to the page fault. If a value of the 3 bits is 000, it may indicate that the page table granularity is 4 KB. If the value of the 3 bits is 001, it may indicate that the page table granularity is 16 KB. If the value of the 3 bits is 010, it may indicate that the page table granularity is 64 KB. If the value of the 3 bits is 011, it may indicate that the page table granularity is 2 MB. If the value of the 3 bits is 100, it may indicate that the page table granularity is 32 MB. If the value of the 3 bits is 101, it may indicate that the page table granularity is 512 MB. If the value of the 3 bits is 110, it may indicate that the page table granularity is 1 GB. If the value of the 3 bits is 111, it may indicate that the page table granularity is 16 GB.

**Table 2**

| Page table granularity field (3 bits) | Page table granularity |
|---|---|
| 000 | 4 KB |
| 001 | 16 KB |
| 010 | 64 KB |
| 011 | 2 MB |
| 100 | 32 MB |
| 101 | 512 MB |
| 110 | 1 GB |
| 111 | 16 GB |

It may be understood that page table granularities corresponding to different values of the page table granularity field shown in Table 2 are merely examples. During actual application, there may alternatively be other correspondences between different values of the page table granularity field and different page table granularities. Table 2 does not constitute a limitation on embodiments of this application.

S204: The second node receives the first response. Related descriptions of the first response are consistent with those of the first response in step S203. Details are not described herein again in this embodiment of this application.

When the second node receives the first response, the second node may determine, based on the page fault information carried in the first response, that the first virtual address is subjected to a page fault, and may further determine the fault type of the page fault based on the page fault information. Optionally, the second node may further process, based on the fault type that is of the page fault and that is indicated by the page fault information, the first access request or a plurality of access requests affected by the fault type.

In a first possible embodiment, when the fault type indicated by the page fault information is the retry, the second node may resend the first access request to the first node after receiving the retry prompt sent by the second node. Further, when the page fault information further indicates the page table granularity corresponding to the page fault, the second node may further suspend sending of at least one second access request. The at least one second access request and the first access request correspond to a same page table at the page table granularity, that is, the at least one second access request and the first access request correspond to the same page table, and a page table granularity of the page table is equal to the page table granularity indicated by the page fault information.

In a second possible embodiment, when the fault type indicated by the page fault information is the abort, the second node may abort or skip (skip) sending of the first access request. Further, when the page fault information further indicates the page table granularity corresponding to the page fault, the second node may further abort or skip sending of at least one second access request. The at least one second access request and the first access request correspond to a same page table at the page table granularity, that is, the at least one second access request and the first access request correspond to the same page table, and a page table granularity of the page table is equal to the page table granularity indicated by the page fault information.

In a third possible embodiment, when the fault type indicated by the page fault information is stream disabled, the second node may abort or skip sending of a plurality of access requests corresponding to the stream, where the plurality of access requests include the first access request. An access request other than the first access request in the plurality of access requests may be an access request that corresponds to the stream and that needs to be subsequently sent by the second node to the first node.

In a fourth possible embodiment, the fault type indicated by the page fault information is the SMMU disabled, the second node may abort or skip sending of a plurality of access requests corresponding to the SMMU, where the plurality of access requests include the first access request. An access request other than the first access request in the plurality of access requests may be an access request that corresponds to the SMMU and that needs to be subsequently sent by the second node to the first node.

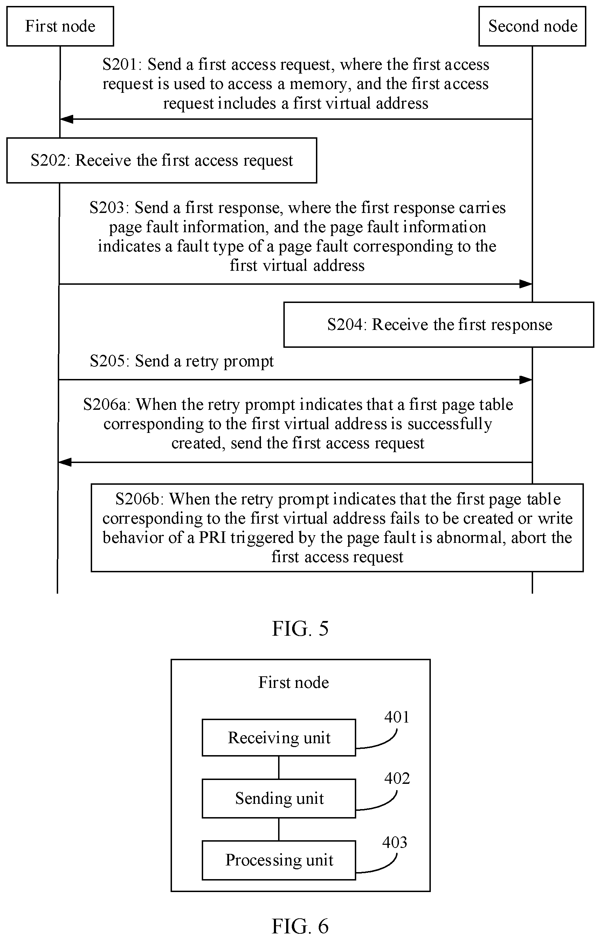

Further, as shown in FIG. 5, when the page fault information indicates that the fault type is the retry, the method may further include S205 to S206b.

S205: The first node sends the retry prompt to the second node.

In a possible embodiment, when the first node determines, based on the first virtual address, that a page fault occurs, and the fault type of the page fault is the retry, the first node may create a first page table corresponding to the first virtual address, and send the retry prompt to the second node based on a creation result. The first page table may indicate the first physical address corresponding to the first virtual address.

Optionally, the retry prompt indicates one of the following information: the first page table corresponding to the first virtual address is successfully created, the first page table corresponding to the first virtual address fails to be created, and write behavior of a page request interface (page request interface, PRI) triggered by the page fault is abnormal. For example, as shown in Table 3, the retry prompt may include an indication field with 2 bits, and the indication field indicates the foregoing information. If a value of the 2 bits is 00, it may indicate that the first page table corresponding to the first virtual address is successfully created. If the value of the 2 bits is 01, it may be reserved (reserved). If the value of the 2 bits is 10, it may indicate that the first page table corresponding to the first virtual address fails to be created. If the value of the 2 bits is 11, it may indicate that the write behavior of the PRI is abnormal. In the foregoing, 01 is a reserved field, and may be further used to define other indication information. This is not limited in embodiments of this application.

**Table 3**

| Indication field (2 bits) | Indicated information |
|---|---|
| 00 | A first page table is successfully created |
| 01 | The first page table fails to be created |
| 10 | Reserved |
| 11 | Write behavior of a PRI is abnormal |

It may be understood that indicated information corresponding to different values of the indication field shown in Table 3 is merely examples. During actual application, there may alternatively be other correspondences between different values of the indication field and different information. Table 3 does not constitute a limitation on embodiments of this application.

For example, as shown in FIG. 4, the UBA of the first node may send a PRI request (which is represented as PRI REQ) to the UBMMU, where PRI REQ may carry SrcID, JFSN, and SSN. After receiving PRI REQ, the UBMMU may send a write PRI queue request (which is represented as Wr PRIQ REQ) to the memory. The memory may return a write PRI queue response (which is represented as Wr PRIQ Resp) to the UBMMU. After receiving Wr PRIQ Resp, the UBMMU sends an interrupter (interrupter) to the CPU. The CPU processes the page fault, for example, creates the first page table corresponding to the first virtual address, and sends a PRI response to the memory. The memory sends a write command response (which is represented as Wr CMD Resp) to the CPU. The CPU sends a write command queue doorbell (doorbell) (which is represented as Wr CMDQ DB) to the UBMMU. After receiving Wr CMDQ DB, the UBMMU sends a PRI response to the UBA. The UBA sends the retry prompt to the UBA of the second node. For example, the retry prompt indicates that the first page table is successfully created. The retry prompt may include SrcID, JFSN, and SSN.

S206a: When the second node receives the retry prompt, and the retry prompt indicates that the first page table corresponding to the first virtual address is successfully created, the second node sends the first access request to the first node.

In a possible embodiment, when the retry prompt received by the second node indicates that the first page table corresponding to the first virtual address has been created, the second node may resend the first access request to the first node based on the retry prompt. In this way, when receiving the first access request sent by the second node, the first node may determine, based on the first page table, the first physical address corresponding to the first virtual address, and access the memory based on the first physical address.

For example, still refer to FIG. 4 in which the method provided in FIG. 3 is applied to the architecture shown in FIG. 2. When the UBA of the second node receives the retry prompt, and the retry prompt indicates that the first page table corresponding to the first virtual address is successfully created, the UBA of the second node may resend the first access request (which is represented as UB REQ Re) to the UBA of the first node. The UBA of the first node receives UB REQ Re, and initiates T REQ to the UBMMU of the first node. When receiving T REQ, the UBMMU may read a page table (namely, a page table walk) from the memory. The memory may return a page table result (namely, a page table result) to the UBMMU. For example, the page table result includes the first page table. The UBMMU may send an address translation result T Rest to the UBA, where T Rest may carry the first physical address that corresponds to the first virtual address and that is determined based on the first page table. When receiving T Rest, the UBA may send a DMA request (which is represented as DMA REQ) to the memory, where DMA REQ may include the first physical address. The memory may return a DMA response (which is represented as DMA Resp) to the UBA. The UBA sends an access response (which is represented as UB Resp ACK) to the UBA of the second node.

S206b: When the second node receives the retry prompt, and the retry prompt indicates that the first page table corresponding to the first virtual address fails to be created or the write behavior of the PRI triggered by the page fault is abnormal, the second node aborts the first access request.

The second node aborting the first access request may alternatively be replaced with that the second node skips (skip) sending of the first access request.

In a possible embodiment, when the retry prompt received by the second node indicates that the first page table corresponding to the first virtual address fails to be created or the write behavior of the PRI triggered by the page fault is abnormal, the second node may abort the first access request based on the retry prompt.

Further, the first response further indicates waiting time, and the waiting time is used by the second node to resend the first access request after the waiting time.

In a possible embodiment, when the first response further indicates the waiting time, after receiving the first response, the second node may resend the first access request to the first node after the waiting time. Optionally, when the page fault information in the first response indicates that the fault type is the retry, and the first response further indicates the waiting time, the second node may resend the first access request to the first node after receiving the retry prompt, or resend the first access request to the first node after the waiting time when the retry prompt is not received. The waiting time may be calculated from a moment at which the second node receives the first response.

Optionally, the waiting time may be time taken by the first node to complete previous page fault processing. The waiting time may be obtained in a manner in which the SMMU, the UBMMU, or the like trains a plurality of page faults in advance, to obtain an initial value, and records latest processing time (which may also be referred to as recording outstanding=1). For different page faults, waiting time indicated by the first response to the second node each time may be time taken for completing processing of a page fault closest to the current page fault.

In embodiments of this application, the first node may receive the first access request from the second node, and send the first response to the second node when the first virtual address included in the first access request is subjected to a page fault. The first response carries the page fault information, and the page fault information indicates the fault type of the page fault corresponding to the first virtual address. Therefore, the second node may process the first access request in time based on the fault type of the page fault, or process the plurality of access requests related to the fault type, to reduce time for the second node to wait for completion of page missing processing, and reduce network congestion caused by the page fault. In addition, when the fault type is the retry, the first node may further send the retry prompt to the second node, so that the second node resends the first access request based on the retry prompt, or aborts the first access request. This further reduces the time for the second node to wait for completion of page missing processing, and reduces network congestion caused by the page fault.

The solutions provided in embodiments of this application are mainly described above from a perspective of interaction between the first node and the second node. It may be understood that, to implement the foregoing functions, the first node or the second node includes corresponding hardware structures and/or software modules for performing the functions. A person skilled in the art should easily be aware that, in combination with units and algorithm steps of the examples described in embodiments disclosed in this specification, this application may be implemented by hardware or a combination of hardware and computer software. Whether a function is executed by hardware or hardware driven by computer software depends on particular applications and design constraint conditions of the technical solutions. A person skilled in the art may use different methods to implement the described functions for each specific application. However, it should not be considered that the implementation goes beyond the scope of this application.

In embodiments of this application, the first node and the second node may be divided into functional modules based on the foregoing method examples. For example, the functional modules may be obtained through division based on the corresponding functions, or two or more functions may be integrated into one processing module. The integrated module may be implemented in a form of hardware, or may be implemented in a form of software functional module. It should be noted that, in embodiments of this application, division into the modules is an example, and is merely logical function division. During actual implementation, another division manner may be used.

When an integrated unit is used, FIG. 6 is a diagram of a possible structure of an apparatus for processing a page fault in memory access according to an embodiment of this application. The apparatus may be used as a first node, and the apparatus includes a receiving unit 401, a sending unit 402, and a processing unit 403. In a possible implementation, the receiving unit 401 may be configured to support the apparatus in performing S202 in the foregoing method embodiments. The sending unit 402 is configured to perform S203 in the foregoing method embodiments. The processing unit 403 is configured to perform a related step like determining that a page fault occurs in the foregoing method embodiments.

Further, in a possible embodiment, the sending unit 402 may be further configured to support the apparatus in performing S205 in the foregoing method embodiments. The receiving unit 401 may be further configured to support the apparatus in performing the step of receiving the first access request sent by the second node based on the retry prompt in the foregoing method embodiments.

Based on hardware implementation, in this embodiment of this application, the processing unit 403 may be a processor of the apparatus, the receiving unit 401 may be a receiver of the apparatus, the sending unit 402 may be a transmitter of the apparatus, and the transmitter and the receiver may be usually integrated together to serve as a transceiver. A specific transceiver may also be referred to as a communication interface or an interface circuit.

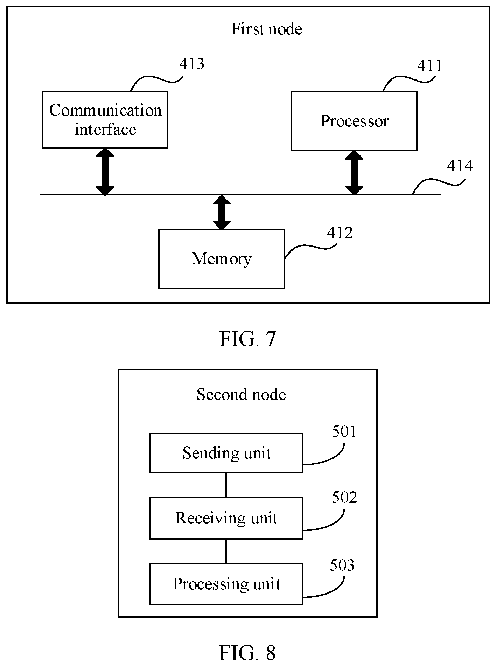

FIG. 7 is a diagram of a possible structure of another apparatus for processing a page fault in memory access in the foregoing embodiments according to an embodiment of this application. The apparatus may be used as a first node. The apparatus includes a processor 411, and may further include a memory 412, a communication interface 413, and a bus 414. The processor 411, the memory 412, and the communication interface 413 are connected through the bus 414. The SMMU and the MMU of the first node described above may be located in the memory 412, and the memory 412 may include a memory.

The processor 411 is configured to control and manage an action of the apparatus, and the processor 411 is configured to perform the step of determining that a page fault occurs in the foregoing method embodiments, or another technical process described in this specification. The communication interface 413 is configured to support the apparatus in communicating, for example, support the apparatus in communicating with a second node.

In this embodiment of this application, the processor 411 may be a central processing unit, a general-purpose processor, a digital signal processor, an application-specific integrated circuit, a field programmable gate array or another programmable logic device, a transistor logical device, a hardware component, or any combination thereof. The processor may implement or execute various example logical blocks, modules, and circuits described with reference to content disclosed in this application. Alternatively, the processor may be a combination of processors implementing a computing function, for example, a combination of one or more microprocessors, or a combination of the digital signal processor and a microprocessor. The bus 414 may be a peripheral component interconnect (peripheral component interconnect, PCI) bus, an extended industry standard architecture (extended industry standard architecture, EISA) bus, or the like. The bus may be classified into an address bus, a data bus, a control bus, and the like. For ease of representation, only one thick line is used to represent the bus in the foregoing figure, but this does not mean that there is only one bus or only one type of bus.

When an integrated unit is used, FIG. 8 is a diagram of a possible structure of an apparatus for processing a page fault in memory access according to an embodiment of this application. The apparatus may be used as a second node, and the apparatus includes a sending unit 501, a receiving unit 502, and a processing unit 503. In a possible implementation, the sending unit 501 is configured to support the apparatus in performing S201 in the foregoing method embodiments. The receiving unit 502 is configured to support the apparatus in performing S204 in the foregoing method embodiments.

Further, in a possible embodiment, the receiving unit 502 may be further configured to support the apparatus in performing the step of sending the retry prompt in S205 in the foregoing method embodiments, and/or S206a in the foregoing method embodiments. The processing unit 503 may be further configured to support the apparatus in performing S206b in the foregoing method embodiments, and/or another technical process described in this specification.

Based on hardware implementation, in this embodiment of this application, the processing unit 503 may be a processor of the apparatus, the sending unit 501 may be a transmitter of the apparatus, the receiving unit 502 may be a receiver of the apparatus, and the transmitter and the receiver may be usually integrated together to serve as a transceiver. A specific transceiver may also be referred to as a communication interface or an interface circuit.

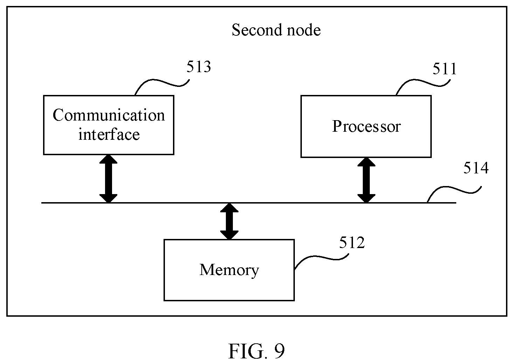

FIG. 9 is a diagram of a possible structure of another apparatus for processing a page fault in memory access in the foregoing embodiments according to an embodiment of this application. The apparatus may be used as a second node. The apparatus includes a processor 511, and may further include a memory 512, a communication interface 513, and a bus 514. The processor 511, the memory 512, and the communication interface 513 are connected through the bus 514. The SMMU and the MMU of the second node described above may be located in the memory 512, and the memory 512 may include a memory.

The processor 511 is configured to control and manage an action of the apparatus. In a possible embodiment, the processor 511 may be configured to support the apparatus in performing S206b in the foregoing method embodiments and another technical process described in this specification. The communication interface 513 is configured to support the apparatus in communicating, for example, support the apparatus in communicating with a first node.

In this embodiment of this application, the processor 511 may be a central processing unit, a general-purpose processor, a digital signal processor, an application-specific integrated circuit, a field programmable gate array or another programmable logic device, a transistor logical device, a hardware component, or any combination thereof. The processor may implement or execute various example logical blocks, modules, and circuits described with reference to content disclosed in this application. Alternatively, the processor may be a combination of processors implementing a computing function, for example, a combination of one or more microprocessors, or a combination of the digital signal processor and a microprocessor. The bus 514 in the foregoing figure may be a peripheral component interconnect PCI bus, an extended industry standard architecture EISA bus, or the like. The bus may be classified into an address bus, a data bus, a control bus, and the like. For ease of representation, only one thick line is used to represent the bus in the foregoing figure, but this does not mean that there is only one bus or only one type of bus.

All related content of each step involved in the foregoing method embodiments may be referenced to a function description of a corresponding functional module. Details are not described herein again. The nodes (for example, the first node and the second node) provided in embodiments of this application are configured to perform functions of corresponding devices in the foregoing embodiments, and therefore can achieve same effect as the foregoing method.

In a possible embodiment, the apparatus for processing the page fault in memory access may be a server. For example, the server may be a server in a cloud network. For example, an embodiment of this application further provides a server. The server includes a processor, a memory, and a communication interface that are coupled to each other. The memory stores instructions, and the processor is configured to execute the instructions in the memory, and perform communication through the communication interface, so that the server implements the steps of the first node in the foregoing method embodiments. For another example, an embodiment of this application further provides a server. The server includes a processor, a memory, and a communication interface that are coupled to each other. The memory stores instructions, and the processor is configured to execute the instructions in the memory, and perform communication through the communication interface, so that the server implements the steps of the second node in the foregoing method embodiments.

According to another aspect, this application provides a communication network. The communication network may include a first node and a second node that are connected over the network. The first node may include the apparatus shown in FIG. 6 or FIG. 7, and is configured to implement the steps of the first node in the foregoing method embodiments. The second node may include the apparatus shown in FIG. 8 or FIG. 9, and is configured to implement the steps of the second node in the foregoing method embodiments.

According to another aspect, this application further provides a chip. The chip includes a processor and an interface circuit. The interface circuit is configured to support the processor in communicating with an off-chip memory. The processor is configured to perform the steps of the first node in the foregoing method embodiments, or the steps of the second node in the foregoing method embodiments.

According to another aspect, this application further provides a chip system. For example, the chip system may be a system on chip (system on chip, SoC). The chip system is configured to perform the steps of the first node in the foregoing method embodiments, or the steps of the second node in the foregoing method embodiments.

According to another aspect, this application further provides a vehicle. The vehicle may be configured to perform the steps of the first node in the foregoing method embodiments, or the steps of the second node in the foregoing method embodiments.

According to another aspect, this application provides a computer-readable storage medium. The computer-readable storage medium stores a computer program or instructions, and when the computer program or the instructions is/are run, the steps of the first node in the foregoing method embodiments are implemented.

According to another aspect, this application provides a computer-readable storage medium. The computer-readable storage medium stores a computer program or instructions, and when the computer program or the instructions is/are run, the steps of the second node in the foregoing method embodiments are implemented.

According to another aspect, this application provides a computer program product. The computer program product includes a computer program (which may also be referred to as code or instructions), and when the computer program is run, a computer is enabled to perform the steps of the first node in the foregoing method embodiments.

According to another aspect, this application provides a computer program product. The computer program product includes a computer program (which may also be referred to as code or instructions), and when the computer program is run, a computer is enabled to perform the steps of the second node in the foregoing method embodiments.

The foregoing descriptions about implementations allow a person skilled in the art to clearly understand that, for the purpose of convenient and brief description, division into the foregoing functional modules is used as an example for illustration. During actual application, the foregoing functions can be allocated to different modules and implemented based on a requirement, that is, an inner structure of an apparatus is divided into different functional modules to implement all or some of the functions described above.

In the several embodiments provided in this application, it should be understood that the disclosed apparatus and method may be implemented in another manner. For example, the described apparatus embodiments are merely examples. For example, division into the modules or the units is merely logical function division and may be other division during actual implementation. For example, a plurality of units or components may be combined or integrated into another apparatus, or some features may be ignored or not performed. In addition, the displayed or discussed mutual coupling or direct coupling or communication connection may be implemented through some interfaces. The indirect coupling or communication connection between the apparatuses or units may be implemented in an electronic form, a mechanical form, or another form.

The units described as separate parts may or may not be physically separate, and parts displayed as units may be one or more physical units, may be located in one place, or may be distributed on different places. Some or all of the units may be selected based on actual requirements to achieve objectives of the solutions of embodiments.

In addition, functional units in embodiments of this application may be integrated into one processing unit, or each of the units may exist alone physically, or two or more units are integrated into one unit. The integrated unit may be implemented in a form of hardware, or may be implemented in a form of software functional unit.

When the integrated unit is implemented in the form of software functional unit and sold or used as an independent product, the integrated unit may be stored in a readable storage medium. Based on such an understanding, the part essentially contributing to the technical solutions in embodiments of this application or all or some of the technical solutions may be implemented in a form of software product. The software product is stored in a storage medium and includes several instructions for instructing a device (which may be a single-chip microcomputer, a chip or the like) or a processor to perform all or some of the steps of the methods described in embodiments of this application. The foregoing storage medium includes any medium that can store program code, for example a USB flash drive, a removable hard disk, a read-only memory, a random access memory, a magnetic disk, or an optical disc.

Finally, it should be noted that the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A method for processing a page fault in memory access, wherein the method comprises:
receiving a first access request, wherein the first access request is used to access memory, and the first access request comprises a first virtual address; and
sending a first response, wherein the first response carries page fault information, and the page fault information indicates a fault type of a page fault corresponding to the first virtual address.

2. The method according to claim 1, wherein the fault type is at least one of the following types: retry, abort, stream accessed by the first access request disabled, and system memory management unit SMMU disabled.

3. The method according to claim 2, wherein the page fault information indicates that the fault type is retry, and the method further comprises:
sending a retry prompt, wherein the retry prompt indicates at least one of the following information: a first page table corresponding to the first virtual address has been created, the first page table corresponding to the first virtual address fails to be created, and write behavior of a page request interface PRI triggered by the page fault is abnormal.

4. The method according to claim 3, wherein the retry prompt indicates that the first page table corresponding to the first virtual address has been created, and the method further comprises:
receiving the first access request sent based on the retry prompt; and
determining, based on the first page table, a first physical address corresponding to the first virtual address, and accessing the memory based on the first physical address.

5. The method according to claim 2, wherein if a result of a page table walk performed based on the first virtual address is a fault, the page fault information indicates that the fault type of the page fault is the abort.

6. The method according to any one of claims 1 to 5, wherein the page fault information further indicates a page table granularity corresponding to the page fault.

7. The method according to any one of claims 1 to 6, wherein the first response further indicates required waiting time for resending the first access request.

8. The method according to any one of claims 1 to 7, wherein before sending the first response, the method further comprises:
determining, based on the first virtual address, that a page fault occurs.

9. A method for processing a page fault in memory access, wherein the method comprises:
sending a first access request, wherein the first access request is used to access memory, and the first access request comprises a first virtual address; and
receiving a first response, wherein the first response carries page fault information, and the page fault information indicates a fault type of a page fault corresponding to the first virtual address.

10. The method according to claim 9, wherein the method further comprises:
processing, based on the fault type that is of the page fault and that is indicated by the page fault information, one or more access requests corresponding to the fault type, wherein the one or more access requests comprise the first access request.

11. The method according to claim 9 or 10, wherein the fault type is at least one of the following types: retry, abort, stream accessed by the first access request disabled, and system memory management unit SMMU disabled.

12. The method according to claim 11, wherein the page fault information indicates that the fault type is the retry, and the method further comprises:
receiving a retry prompt, wherein the retry prompt indicates at least one of the following information: a first page table corresponding to the first virtual address has been created, the first page table corresponding to the first virtual address fails to be created, and write behavior of a page request interface PRI triggered by the page fault is abnormal.

13. The method according to claim 12, wherein the retry prompt indicates that the first page table corresponding to the first virtual address has been created, and the method further comprises:
sending the first access request based on the retry prompt.

14. The method according to claim 12, wherein the retry prompt indicates that the first page table corresponding to the first virtual address fails to be created, or indicates that the write behavior of the PRI triggered by the page fault is abnormal, and the method further comprises:
aborting or skipping sending of the first access request based on the retry prompt.

15. The method according to claim 11, wherein the page fault information indicates that the fault type is the abort, and the method further comprises:
aborting or skipping sending of the first access request based on the page fault information.

16. The method according to any one of claims 9 to 15, wherein the page fault information further indicates a page table granularity corresponding to the page fault.

17. The method according to claim 16, wherein the first access request and at least one second access request correspond to a same page table at the page table granularity, and the method further comprises:
when the page fault information indicates that the fault type is the retry, suspending sending of the at least one second access request; and
when the page fault information indicates that the fault type is the abort, aborting or skipping sending of the at least one second access request.

18. The method according to claim 11, wherein the page fault information indicates that the fault type is the stream accessed by the first access request disabled, and the method further comprises:
aborting or skipping sending of a plurality of access requests corresponding to the stream, wherein the plurality of access requests comprise the first access request.

19. The method according to claim 11, wherein the page fault information indicates that the fault type is the SMMU disabled, and the method further comprises:
aborting or skipping sending of a plurality of access requests corresponding to the SMMU, wherein the plurality of access requests comprise the first access request.

20. The method according to any one of claims 9 to 19, wherein the first response further indicates required waiting time for resending the first access request.

21. An apparatus for processing a page fault in memory access, wherein the apparatus comprises:
a receiving unit, configured to receive a first access request, wherein the first access request is used to access memory, and the first access request comprises a first virtual address; and
a sending unit, configured to send a first response, wherein the first response carries page fault information, and the page fault information indicates a fault type of a page fault corresponding to the first virtual address.

22. The apparatus according to claim 21, wherein the fault type is at least one of the following types: retry, abort, stream accessed by the first access request disabled, and system memory management unit SMMU disabled.

23. The apparatus according to claim 22, wherein the page fault information indicates that the fault type is the retry; and
the sending unit is further configured to send a retry prompt, wherein the retry prompt indicates at least one of the following information: a first page table corresponding to the first virtual address has been created, the first page table corresponding to the first virtual address fails to be created, and write behavior of a page request interface PRI triggered by the page fault is abnormal.

24. The apparatus according to claim 23, wherein the retry prompt indicates that the first page table corresponding to the first virtual address has been created, and the apparatus further comprises a processing unit;
the receiving unit is further configured to receive the first access request sent based on the retry prompt; and
the processing unit is further configured to determine, based on the first page table, a first physical address corresponding to the first virtual address, and access the memory based on the first physical address.

25. The apparatus according to claim 22, wherein if a result of a page table walk performed based on the first virtual address is a fault, the page fault information indicates that the fault type of the page fault is the abort.

26. The apparatus according to any one of claims 21 to 25, wherein the page fault information further indicates a page table granularity corresponding to the page fault.

27. The apparatus according to any one of claims 21 to 26, wherein the first response further indicates required waiting time for resending the first access request.

28. The apparatus according to any one of claims 21 to 27, wherein the apparatus further comprises:
the processing unit, configured to determine, based on the first virtual address, that a page fault occurs.

29. An apparatus for processing a page fault in memory access, wherein the apparatus comprises:
a sending unit, configured to send a first access request, wherein the first access request is used to access memory, and the first access request comprises a first virtual address; and
a receiving unit, configured to receive a first response, wherein the first response carries page fault information, and the page fault information indicates a fault type of a page fault corresponding to the first virtual address.

30. The apparatus according to claim 29, wherein the apparatus further comprises:
a processing unit, configured to process, based on the fault type that is of the page fault and that is indicated by the page fault information, one or more access requests corresponding to the fault type, wherein the one or more access requests comprise the first access request.

31. The apparatus according to claim 29 or 30, wherein the fault type is at least one of the following types: retry, abort, stream accessed by the first access request disabled, and system memory management unit SMMU disabled.

32. The apparatus according to claim 31, wherein the page fault information indicates that the fault type is the retry; and
the receiving unit is further configured to receive a retry prompt, wherein the retry prompt indicates at least one of the following information: a first page table corresponding to the first virtual address has been created, the first page table corresponding to the first virtual address fails to be created, and write behavior of a page request interface PRI triggered by the page fault is abnormal.

33. The apparatus according to claim 32, wherein the retry prompt indicates that the first page table corresponding to the first virtual address has been created, and
the sending unit is further configured to send the first access request based on the retry prompt.

34. The apparatus according to claim 32, wherein the retry prompt indicates that the first page table corresponding to the first virtual address fails to be created, or indicates that the write behavior of the PRI triggered by the page fault is abnormal, and the apparatus further comprises:
the processing unit, configured to abort or skip sending of the first access request based on the retry prompt.

35. The apparatus according to claim 31, wherein the page fault information indicates that the fault type is the abort, and the apparatus further comprises:
the processing unit, configured to abort or skip sending of the first access request based on the page fault information.

36. The apparatus according to any one of claims 29 to 35, wherein the page fault information further indicates a page table granularity corresponding to the page fault.

37. The apparatus according to claim 36, wherein the first access request and at least one second access request correspond to a same page table at the page table granularity, and the apparatus further comprises:
the processing unit, configured to: when the page fault information indicates that the fault type is the retry, suspend sending of the at least one second access request, wherein
the processing unit is further configured to: when the page fault information indicates that the fault type is the abort, abort the at least one second access request.

38. The apparatus according to claim 31, wherein the page fault information indicates that the fault type is the stream accessed by the first access request disabled, and the apparatus further comprises:
the processing unit, configured to abort or skip sending of a plurality of access requests corresponding to the stream, wherein the plurality of access requests comprise the first access request.

39. The apparatus according to claim 31, wherein the page fault information indicates that the fault type is the SMMU disabled, and the apparatus further comprises:
the processing unit, configured to abort or skip sending of a plurality of access requests corresponding to the SMMU, wherein the plurality of access requests comprise the first access request.

40. The apparatus according to any one of claims 29 to 39, wherein the first response further indicates required waiting time for resending the first access request.

41. A chip, wherein the chip comprises a processor and an interface circuit, the interface circuit is configured to support the processor in communicating with an off-chip memory, and the processor is configured to perform the method according to any one of claims 1 to 20.

42. An apparatus for processing a page fault in memory access, wherein the apparatus comprises a processor and a memory, the memory stores instructions, and when the processor runs the instructions, the apparatus is enabled to perform the method according to any one of claims 1 to 20.

43. A communication network, wherein the communication network comprises a first node and a second node, the first node comprises the apparatus according to any one of claims 21 to 28, and the second node comprises the apparatus according to any one of claims 29 to 40.

44. A computer-readable storage medium, wherein the computer-readable storage medium stores a computer program or instructions, and when the computer program or the instructions is/are run, the method according to any one of claims 1 to 20 is implemented.
